# EUROPEAN PATENT SPECIFICATION

(11) **EP 0 522 622 B1**
(45) Date of publication and mention of the grant of the patent: **31.05.1995**
(21) Application number: 92201824.7
(22) Date of filing: 22.06.1992
(51) Int. Cl.: H01G 4/30, H05K 3/46

(54) **Composite green ceramic layer**
Zusammengesetzte grüne keramische Schicht
Couche céramique composite non frittée

(30) Priority: 26.06.1991 NL 9101108
(43) Date of publication of application: 13.01.1993
(73) Proprietor: DSM N.V., 6411 TE Heerlen (NL)
(72) Inventor: Höppener, Roderik Hubrecht, NL-6212 CG Maastricht (NL)

(56) References cited:
- WO-A-91/01346
- DE-A- 3 507 320
- US-A- 3 179 545
- DATABASE WPIL Week 9114, Derwent Publications Ltd., London, GB; AN 91-098871;& JP-A-3 044 020
- IBM TECHNICAL DISCLOSURE BULLETIN. vol. 16, no. 9, February 1974, New York,US;pages 2887 - 2888 J.F. FUGARDI et al.: "Multilayer ceramic by slurry casting over metallization"

## Description

The invention relates to a process for the production of a composite green ceramic layer comprising the application of electrodes on a base layer consisting of a green ceramic film and the application of a ceramic finishing layer which at least fills the spaces between the electrodes.

Such a process is known from DE-OS-3507320. The finishing layer therein is applied by screen printing. The homogeneity of the layers thus applied is not satisfactory and that is why a relatively thick layer must be applied to make sure that the finishing layer does not contain impermissibly thin spots or even holes. The continuing miniaturization of electronic components requires layers thinner than those which can be produced by the the known process. A more attractive process of applying the finishing layer is tape casting. Problems relating to the attack of the ceramic base layer by the solvents used in said process have so far prohibited the application of this technique, which usually was applied in the production of the base layer, and therefore no composite ceramic layers are known of which the finishing layer has been applied onto the green ceramic film by tape casting.

The object of the invention is to provide a process by which very thin and strong composite ceramic layers can be produced in which the individual ceramic layers, and consequently the finishing layer, too, are applied by tape casting.

This object is achieved according to the invention in that the ceramic film is self-supporting, has a thickness of 40 »m at most, consists for at least 45% (by volume) of ceramic material and has been produced from a thermoreversibly gelling solution of a binding agent with the ceramic material suspended therein, and that the finishing layer is applied by tape casting.

It has surprisingly been found that while using the specified very thin ceramic film as the base layer it is possible to apply the finishing layer by tape casting. Besides the advantage that, by applying the process according to the invention, composite layers with very small total thicknesses can be produced, it is an advantage also that the process can be carried out as a continuous process, unlike screen printing, which is used for the application of ceramic layers in a batch process only. The rate of production of the process according to the invention is therefore many times higher than that of the known process.

The thickness of the ceramic film used as base layer is preferably 25 »m at most. After sintering, the thickness of the resulting ceramic base layer is usually less than 20, preferably less than 15 »m and more preferably less than 10 »m.

The composite ceramic layer obtained has a small thickness, which has so far not been achieved, and at the same time it is very well manageable.

From JP-A-90/58816, too, a composite ceramic layer is known. In said composite layer the base layer does not consist of a ceramic film, but of a polyethylene terephthalate (PET) film and a layer of polyvinyl butyral (PVB) applied on top. On this layer of polyvinyl butyral, electrodes have been applied and over the electrodes and the parts of the polybutyral layer left exposed by them a finishing layer has been applied consisting of a layer of dried ceramic paste. This paste layer has been applied by tape casting. To enable the composite layer to be further used as a constituent layer in an electronic component the PET layer must be removed. The polyvinyl butyral layer serves as a release layer to facilitate said removal of the PET layer from the electrodes and the finishing layer.

A disadvantage of this composite ceramic layer known from JP-A-90/58816 is that before the stacking of a plurality of these layers to form a multi-layer electronic component, the PET film must be removed from every layer. Besides constituting an extra process step, this also entails a risk of damaging the layer of dried ceramic paste, which is often only about twenty microns thick.

The composite green ceramic layer obtained according to the invention can be used to produce a multilayer electronic component more conveniently and with a far smaller risk of damage than the composite layer known from JP-A-90/58816.

By virtue of its composition, the base layer contained in it is suited as a whole to form part of the ceramic electronic component and need not therefore be removed in whole or in part, which makes it possible for the composite layer according to the invention to be incorporated as a whole, without further processing, in a multi-layer assembly.

A further advantage of the composite layer obtained according to the invention is the absence of a release layer. In the production of an electronic component from composite layers according to the state of the art, the release layer is removed completely by burning it out in the process then applied, which may leave cavities in the electronic component. The presence of such cavities interferes with the reproducible production of the components, raises the loss percentage and is very harmful for the dielectric properties and the reliability of the final electronic components.

Multi-layer electronic components are known per se and they consist of a stacked repeated pattern of layers with different functions, for instance in the case of a capacitor such pattern is formed by a layer of electrodes and a dielectric layer. In the stack, the layer of electrodes is then incorporated between two dielectric layers. The repeated pattern can be obtained by applying the layers with the different functions in their correct order on top of each other, but also by stacking identical composite layers already incorporating the various functions in their correct order. Composite layers offer an advantage both in the production thereof and in the further process for the formation of a multi-layer electronic component, because for both process steps only one kind of layer need be reckoned with.

The invention will be elucidated hereinafter by means of some embodiments shown in the drawing. In the drawing
Fig. 1 is a section of a first embodiment of the composite green ceramic layer obtained according to the invention;
Fig. 2 a section of a second embodiment of the composite green ceramic layer obtained according to the invention;
Fig. 3 a section of a stacked structure consisting of two layers obtained according to the second embodiment and
Fig. 4 a diagrammatic section of a multi-layer electronic component made of composite layers obtained according to the invention, perpendicular to the plane of these layers, in which the positions of the electrodes are shown.

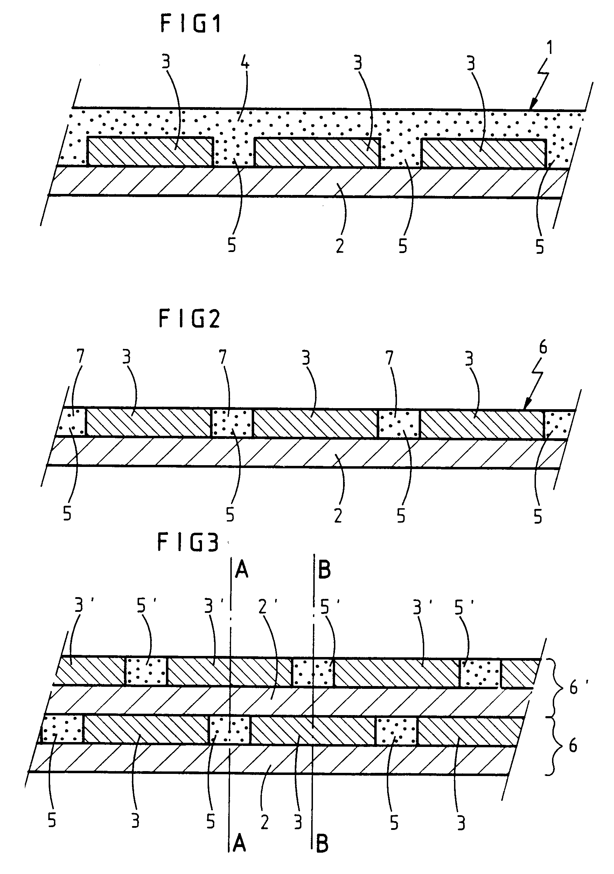

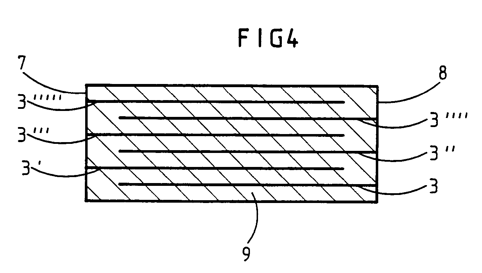

In fig. 1, **1** is a first embodiment of the composite green ceramic layer obtained according to the invention. This layer **1** consists of a base layer **2** with electrodes **3** on top. A ceramic finishing layer **4** covers electrodes **3** and fills the spaces **5** in between. In a second embodiment of the composite layer obtained according to the invention, represented by **6** in fig. 2, finishing layer **7** has been applied only in spaces **5** between electrodes **3**. In fig. 3, **6** and **6**′ are layers according to the second embodiment as represented in fig. 2, stacked one on top of the other. In the stacked structure electrodes **3**′ of layer **6**′ are staggered in respect of electrodes **3** of layer **6**. According to this principle multi-layer components can be built up by the staggered stacking of the desired number of layers. Lines **A-A** and **B-B** indicate two of the lines along which the stacked structure is cut to form separate multi-layer components. These lines proceed alternately through the middle of the electrodes and of the openings between the electrodes of a composite layer. The effect is that in the successive layers of the multi-layer component cut from the stacked structure the electrodes end alternately on opposite surfaces. This is illustrated in fig. 4, in which a diagrammatic section perpendicular to the composite layers of a sintered six-layer component is shown. This component has been formed from a stacked structure of six layers built up according to the principle shown in fig. 3, in respect of which layers **6**˝, **6**‴, **6**˝˝ and **6**‴˝ have yet been added, however, containing electrodes **3**˝, **3**‴, **3**˝˝ and **3**‴˝. Sides **7** and **8** have been formed by cutting the stacked structure of six layers built up as described above according to the planes indicated by **A-A** and **B-B** in fig. 3. Electrodes **3** - **3‴**˝ in the successive layers end alternately on the opposing sides 7 and 8 and are further surrounded with homogeneous ceramic material **9** left behind after burning out the binding agents from the base layers and the finishing layers. On the topmost composite layer an extra ceramic layer has been applied to cover electrode **3**‴˝.

The composite layer obtained according to the invention comprises a base layer, electrodes and a ceramic layer. The base layer consists of a self-supporting green ceramic film, which is self-supporting, has a thickness of 40 »m at most and preferably 25 »m at most and has been produced from a thermoreversibly gelling solution of a binding agent with the ceramic material suspended therein. The finishing layer has been applied by tape casting. In the relevant sector of the art a green ceramic film is generally understood to mean a film in which a binding agent is present in addition to the ceramic material. Such films are known per se, for instance from EP-A-210 874, in which cellulose resins are used as binding agents for ceramic powder, and from WO-91/01346, in which polymers with a high molecular weight are used as binders. According to WO-91/01346 a self-supporting green ceramic film can be obtained in the form of a particularly thin layer, for instance thinner than 40 or even 25 »m, with a high content of ceramic material if it is produced from a thermoreversibly gelling solution of a binding agent with the ceramic material suspended therein. By, for instance, extruding or moulding this solution into a film, followed by the rapid cooling of the film formed from and consisting of said solution, in which process a gel film is formed, and by removing the solvent from this gel film a self-supporting green ceramic film is obtained. Therefore, the base layer used is preferably a ceramic green film with the desired thickness and ceramic material content produced according to the process of WO-91/01346.

Highly suitable binding agents are polyvinyl alcohol, linear polyethylene and higher polyalkenes. The binding agent used is preferably polyethylene with an intrinsic viscosity of at least 5 dl/g, corresponding with a weight-average molecular weight of at least about 500,000 g/moles. It can be used already for obtaining very strong self-supporting green ceramic films having thicknesses of less than 40 »m and even less than 25 »m.

The ceramic material used for the base layer and the finishing layer may be any inorganic material with suitable electric and dielectric properties, for instance aluminium oxide, barium titanate, zinc oxide, zirconium oxide, lithium niobate, (metal-filled) glass, ceramic substances and relaxors such as complex lead oxides. On account of their favourable dielectric properties, the ceramic materials used in capacitors are preferably aluminium oxide and barium titanate.

In order to minimize the risk of the formation of cavities in burning out the green ceramic film, the amount of ceramic material in this film must be very substantial, and preferably the film consists for at least 45% by volume of ceramic material.

The electrodes may consist of the materials usually applied for this purpose, for instance palladium, palladium-silver alloys and nickel, and may be 1-10 »m thick.

The ceramic finishing layer may consist of any substance that contains ceramic material and that can be applied in the desired thickness, for instance a paste consisting of ceramic powder and a binding agent. The thickness may range from the thickness of the electrodes, as in a composite layer in the embodiment shown in fig. 2, to a few tens of »m if the finishing layer is applied also over the electrodes. The finishing layer is preferably as thin as mechanically permissible because a component built up from thinner layers generally already possesses certain properties with a smaller volume than a component built up from thicker layers.

The composite layer is preferably produced in the manner described below.

On the base layer obtained according to any one of the above-mentioned processes, or any other suitable process, electrodes are placed in the desired pattern using one of the techniques known for that purpose, for instance screen printing, chemical or physical vapour deposition, sputtering or gravure coating. With their thickness, which is for instance 2-3 »m, the electrodes thus project above the base layer. Subsequently, a ceramic finishing layer is applied over the base layer provided with electrodes. The finishing layer serves to fill up the spaces between the electrodes and thus to eliminate the differences in thickness caused by the presence of the electrodes. The finishing layer is applied in the desired thickness by tape casting a ceramic paste over the base layer provided with electrodes. In the composite layer known from JP-A-90/58816 the finishing layer must also be firm enough to make the composite layer manageable and the finishing layer must therefore in that case be about 15-20 »m thick. Unlike this known composite layer, the composite layer according to the invention is already firm enough by virtue of the self-supporting base layer, so that a much thinner finishing layer will suffice as long as it fills at least the spaces between the electrodes (see fig. 2). The advantage is that the thickness of the composite layer according to the invention may be considerably smaller than the thickness of the known composite layer. If so desired, in the composite layer according to the invention the finishing layer may also be thicker and cover the electrodes completely (see fig. 1).

A further advantage of the composite layer obtained according to the invention is the fact that the base layer has a certain porosity, so that during the drying of the electrodes and of the finishing layer applied thereon the solvents may escape from it on both sides of the composite layer, which may reduce the drying period.

The composite green ceramic layer obtained according to the invention is particularly suited for the production of multi-layer electronic components. The invention therefore also relates to the use of the composite ceramic layer obtained according to the invention for the production of a multi-layer electronic component.

Processes for the production of multi-layer electronic components from composite ceramic layers are known per se, for instance from the patent applications mentioned above.

It has been found that multi-layer ceramic electronic components produced from composite green ceramic layers obtained according to the invention are so thin as not to be equalled and very compact, are virtually free from cavities thanks to the absence of a release layer to be removed by burning out during the sintering process and have very good dielectric properties and a high degree of reliability.

The composite layers are stacked one on top of another while taking into account the positions of the electrodes in the successive layers. For instance, for the production of multi-layer ceramic capacitors a composite layer is used with the electrodes forming a regular repeated pattern. The successive layers are so stacked that in every layer the electrode pattern is staggered in respect of that of the adjoining layers. The stacked structure is subsequently cut to form individual components. This is illustrated in fig. 3. This technique and the like for the positioning of electrodes in electric components and for the production of multi-layer componentns in general are known per se in the relevant sector of the art, for instance from 'Electronic Ceramics', Lionel M. Levinson ed., Marcel Dekker, Inc. New York, ISBN 0-8247-7761-1, particularly section 4.6. In it are described also the techniques for drying, compressing, burning out and sintering the cut stacked structure thus obtained. During the burning-out process the binding agents decompose and escape from the base layer and the finishing layer and during the sintering the ceramic material is treated to form a coherent mass in close contact with the electrodes. Further treatment then comprises the installation of the electrode-linked external connections and the placement, if so desired, in a package.

The composite layers obtained according to the invention are used as substrates in multi-layer hybrid circuits, capacitors, resistors, varistors, piezo-electric and electro-optical components and sensing elements.

The invention will be elucidated by means of the following examples without, however, being limited thereto. The parameters mentioned have been determined as described below.

The intrinsic viscosity of polyethylene is determined in decalin at 135°C.

Capacity and tg δ are determined at 25°C at a voltage of 1 Vᵣₘₛ and 1 kHz according to the MIL-STD-202F standard, method 305.

### Example I

A green ceramic film is produced according to the process of WO-91/01436 from polyethylene with an intrinsic viscosity of 8 dl/g as binding agent and barium titanate as ceramic material. The film is 12 »m thick, corresponding with a thickness of 3 »m after sintering. On this base layer an electrode pattern of palladium/silver is applied by screen printing, suitable for capacitors measuring 0.30 x 0.20 mm (0.012 x 0.008 inch). The finishing layer applied after the drying of the electrode pattern consists of a layer of barium titanate/polyvinyl butyral paste, with toluene as solvent, having a thickness corresponding with a thickness after sintering of 7 »m. After the drying of the finishing layer, the film is cut into strips, of which ten are stacked one on top of another and compressed. After cutting the stacked and compressed structure, the resulting green multi-layer ceramic electronic components are subjected to a temperature treatment. In this treatment the polyethylene and polyvinyl butyral binding agents are burnt out by heating the structure to 300°C, subsequently heating the structure in 18 hours from 300°C to 600°C, then cooling it and finally sintering it for 2 hours at 1300°C.

In the resulting multi-layer capacitors with a dielectric layer thickness of 10 »m, the capacity is 90 nF and the tg δ 0.018.

## Claims

1. Process for the production of a composite green ceramic layer (1) comprising the application of electrodes (3) on a base layer (2) consisting of a green ceramic film and the application of a ceramic finishing layer (4) which at least fills the spaces (5) between the electrodes (3), characterized in that the ceramic film is self-supporting, has a thickness of 40 »m at most, consists for at least 45% by volume of ceramic material and has been produced from a thermoreversibly gelling solution of a binding agent with the ceramic material suspended therein and in that the finishing layer is applied by tape casting.

2. Process according to claim 1, characterized in that the binding agent substantially consists of polyethylene with an intrinsic viscosity of at least 5 dl/g.

3. Process according to any one of claims 1 or 2, characterized in that the thickness of the ceramic film is 25 »m at most.

4. Use of the composite ceramic layer obtained by the process according to any one of claims 1-3 for the production of a multi-layer electronic component.

## Patentansprüche

1. Verfahren zur Herstellung eines Grünkeramikschichtpaketes (1), bei dem Elektroden (3) auf eine Grundschicht (2), die aus einem Grünkeramikfilm besteht, aufgebracht werden und eine Endkeramikschicht (4) die mindestens die Räume (5) zwischen den Elektroden (3) füllt, aufgebracht wird, dadurch gekennzeichnet, daß der Keramikfilm selbsttragend ist, eine Dicke von höchstens 40 »m hat, zu mindestens 45% des Volumens aus keramischem Material besteht und aus einer thermoreversibel gelierenden Lösung eines Bindemittels, in dem das Keramikmaterial suspendiert ist, hergestellt wurde, und daß die Endschicht durch Bandgießen aufgebracht wird.

2. Verfahren nach Anspruch 1, dadurch gekennzeichnet, daß das Bindemittel im wesentlichen aus Polyäthylen mit einer inneren Viskosität von mindestens 5 dl/g besteht.

3. Verfahren nach einem der Ansprüche 1 oder 2, dadurch gekennzeichnet, daß die Dicke des Keramikfilms höchstens 25 »m ist.

4. Verwendung des nach dem Verfahren gemäß einem der Ansprüche 1 bis 3 erhaltenen Keramikschichtpaketes für die Herstellung einer vielschichtigen Elektronikkomponente.

## Revendications

1. Procédé de production d'une couche-céramique composite non frittée (1) consistant à appliquer des électrodes (3) sur une couche de base (2) constituée d'une pellicule céramique non frittée et à appliquer une couche céramique de finition (4) qui remplit au moins les espaces (5) entre les électrodes (3), caractérisé en ce que la pellicule céramique est autonome, présente une épaisseur ne dépassant pas 40 »m, consiste en au moins 45% en volume de matière céramique et a été produite à partir d'une solution gélifiante sur le thermoréversible d'un agent liant dans laquelle la matière céramique est suspendue et en ce qu'on applique la couche de finition par coulée en ruban.

2. Procédé selon la revendication 1, caractérisé en ce que le liant consiste sensiblement en polyéthylène ayant une viscosité intrinsèque d'au moins 5 dl/g.

3. Procédé selon la revendication 1 ou 2, caractérisé en ce que l'épaisseur de la pellicule céramique est au maximum de 25 »m.

4. Utilisation de la couche céramique composite obtenue par le procédé selon l'une quelconque des revendications 1 à 3 pour la production d'un composant électronique multicouches.
